# EUROPEAN PATENT APPLICATION

(11) **EP 4 379 463 A1**
(43) Date of publication of application: **05.06.2024**
(21) Application number: 22866663.2
(22) Date of filing: 07.09.2022
(51) Int. Cl.: G03F 1/00, G03F 1/48, G03F 7/00, C23C 14/04

(54) **THIN FILM MASK**

(30) Priority: 10.09.2021 CN 202111063887
(71) Applicant: Longi Green Energy Technology Co., Ltd., Xi'an, Shaanxi 710100 (CN)
(72) Inventor: CAI, Yongan, Xi' an, Shaanxi 710100 (CN)
(74) Representative: Manitz Finsterwald Patent- und Rechtsanwaltspartnerschaft mbB
(86) International application number: PCT/CN2022/117628
(87) International publication number: WO 2023/036200

(57) **Abstract**

The present application provides a thin film mask including a first layer and a second layer; the first layer and the second layer are arranged in layer configuration; the second layer includes an adhesive film; under irradiation of an ultraviolet light source and with a thickness of the first layer being 200 µm or less, an absorption coefficient of the first layer is ≥ 20%, wherein a wavelength of the ultraviolet light source is 355 ± 15 nm; or under irradiation of a green light source and with the thickness of the first layer being 200 µm or less, the absorption coefficient of the first layer is ≥ 20%, wherein a wavelength of the green light source is 530 ± 15 nm; or under irradiation of an infrared light source and with the thickness of the first layer being 200 µm or less, the absorption coefficient of the first layer is ≥ 20%, wherein a wavelength of the infrared light source is 1045 ± 20 nm; and a visible light transmittance of the first layer is ≤ 90%. The optical properties are utilized by the thin film mask provided by the present application, less power for the light source is required and the cost can be saved comparing with a common thin film. Further, by the patterning content formed by a light source with low power consumption, and the cost of the adhesive film is low. A complicated process is not needed to be matched with to achieve the patterning process, and cost reduction and efficiency increase are achieved.

## Description

The present disclosure claims the priority of the Chinese patent application filed on September 10th, 2021 before the Chinese Patent Office with the application number of 202111063887.5 and the title of "THIN FILM MASK", which is incorporated herein in its entirety by reference.

### TECHNICAL FIELD

The present application relates to the technical field of thin film materials and, more particular, to a thin film mask.

### BACKGROUND

The method of using a thin film mask to make regional patterns is widely used in high-tech fields such as semiconductors, display panels, touch panels, solar cells, circuit masks and precision printing. At present, a commonly used method is to use photoresist development or pattern a metal mask. The photoresist process is complicated, the material cost is high, the subsequent chemical cleaning is required, the cost of environmental requirements is increased. However, when the metal mask is especially applied to a solar cell with concave and convex surfaces, the metal mask cannot be fit to the surface of the solar cell, which results in low accuracy of the patterned content. In addition, periodic maintenance and cleaning are required during use and the maintenance cost is increased.

### SUMMARY

An object of the present application aims at providing a thin film mask, wherein the thin film mask includes a first layer and a second layer; the first layer and the second layer are arranged in layer configuration; and the second layer includes an adhesive film;
under irradiation of an ultraviolet light source and with a thickness of the first layer being 200 µm or less, an absorption coefficient of the first layer is ≥ 20%, wherein a wavelength of the ultraviolet light source is 355 ± 15 nm; or under irradiation of a green light source and with the thickness of the first layer being 200 µm or less, the absorption coefficient of the first layer is ≥ 20%, wherein a wavelength of the green light source is 530 ± 15 nm; or under irradiation of an infrared light source and with the thickness of the first layer being 200 µm or less, the absorption coefficient of the first layer is ≥ 20%, wherein a wavelength of the infrared light source is 1045 ± 20 nm; and
a visible light transmittance of the first layer is ≤ 90%.

Further, under the irradiation of the ultraviolet light source and with the thickness of the first layer being 200 µm or less, the absorption coefficient of the first layer is ≥ 50%; optionally, under the irradiation of the ultraviolet light source and with the thickness of the first layer being 200 µm or less, the absorption coefficient of the first layer is ≥ 80%; or
under the irradiation of the green light source and with the thickness of the first layer being 200 µm or less, the absorption coefficient of the first layer is ≥ 50%; optionally, under the irradiation of the green light source and with the thickness of the first layer being 200 µm or less, the absorption coefficient of the first layer is ≥ 80%; or
under the irradiation of the infrared light source and with the thickness of the first layer being 200 µm or less, the absorption coefficient of the first layer is ≥ 50%; and optionally, under the irradiation of the infrared light source and with the thickness of the first layer being 200 µm or less, the absorption coefficient of the first layer is ≥ 80%.

Further, the first layer includes a polymeric membrane;
a material of the polymeric membrane is a polymer, including one or more of polyethylene glycol terephthalate (PET), polyolefin thin film (PO), polyimide (PI), polyvinyl chloride (PVC), and biaxially oriented polypropylene (BOPP).

Further, the thickness of the first layer is 1-100 µm; optionally, the thickness of the first layer is 5-40 µm; and further optionally, the thickness of the first layer is 10-25 µm.

Further, under the irradiation of the ultraviolet light source and with a thickness of the second layer being 200 µm or less, an absorption coefficient of the second layer is ≥ 5%, wherein the wavelength of the ultraviolet light source is 355 ± 15nm; or under the irradiation of the green light source and with the thickness of the second layer being 200 µm or less, the absorption coefficient of the second layer is ≥ 5%, wherein the wavelength of the green light source is 530 ± 15nm; or, under the irradiation of the infrared light source and with the thickness of the second layer being 200 µm or less, the absorption coefficient of the second layer is ≥ 5%, wherein the wavelength of the infrared light source is 1045 ± 20 nm.

Further, under the irradiation of the ultraviolet light source and with a thickness of the second layer being 200 µm or less, an absorption coefficient of the second layer is ≥ 50%; optionally, under the irradiation of the ultraviolet light source and with the thickness of the second layer being 200 µm or less, the absorption coefficient of the second layer is ≥ 80%; or
under the irradiation of the green light source and with the thickness of the second layer being 200 µm or less, the absorption coefficient of the second layer is ≥ 50%; optionally, under the irradiation of the green light source and with the thickness of the second layer being 200 µm or less, the absorption coefficient of the second layer is ≥ 80%; or
under the irradiation of the infrared light source and with the thickness of the second layer being 200 µm or less, the absorption coefficient of the second layer is ≥ 50%; and optionally, under the irradiation of the infrared light source and with the thickness of the second layer being 200 µm or less, the absorption coefficient of the second layer is ≥ 80%.

Further, a thickness of the second layer is 1-30 µm; optionally, the thickness of the second layer is 2-15 µm; and further optionally, the thickness of the second layer is 3-10 µm.

Further, a material of the adhesive film in the second layer includes one or more of silicone, acrylic adhesive, polyurethane, rubber, and polyisobutylene.

Further, a peeling strength of the second layer at a first temperature is 1-50 gf/cm; optionally, the peeling strength of the second layer is 5-30 gf/cm; and further optionally, the peeling strength of the second layer is 6-15 gf/cm;
wherein the first temperature is 15-30°C; optionally, the first temperature is 20-30°C; further optionally, the first temperature is 20-25 °C.

Further, a material of the adhesive film in the second layer includes a unidirectional thermo-sensitive adhesive, a viscosity of the unidirectional thermo-sensitive adhesive exhibits irreversibility under different temperature conditions; and
a peeling strength of the unidirectional thermo-sensitive adhesive decreases with increasing of a temperature.

Further, a material of the adhesive film in the second layer includes a thermal debonding adhesive, a viscidity of the thermal debonding adhesive exhibits irreversibility at a temperature greater than or equal to a second temperature; and
a peeling strength of the thermal debonding adhesive at the temperature greater than or equal to the second temperature is less than a peeling strength of the thermal debonding adhesive at a temperature less than the second temperature;
wherein the second temperature is 70 °C; optionally, the second temperature is 70-150°C; and further optionally, the second temperature is 90-150°C.

Further, the peeling strength of the unidirectional thermo-sensitive adhesive is 5-30 gf/cm and the temperature is 50-140°C.

Further, a material of the adhesive film in the second layer includes a bidirectional thermo-sensitive adhesive, a viscosity of the bidirectional thermo-sensitive adhesive exhibits reversibility under different temperature conditions; and
a peeling strength of the bidirectional thermo-sensitive adhesive increases with increasing of a temperature.

Further, the peeling strength of the bidirectional thermo-sensitive adhesive is 5-30 gf/cm and the temperature is 50-140°C.

Further, a thickness of the thin film mask is 10-100 µm; optionally, the thickness of the thin film mask is 10-50 µm.

Further, the thin film mask further includes a third layer;
the third layer is arranged in layer configuration at a side of the second layer away from the first layer;
the third layer includes a release film; and
the release film is a polymer, including one or more of polyethylene glycol terephthalate (PET), polyolefin thin film (PO), polyimide (PI), polyvinyl chloride (PVC), and biaxially oriented polypropylene (BOPP).

Further, a thickness of the third layer is 1-100 µm; optionally, the thickness of the third layer is 5-40 µm; and further optionally, the thickness of the third layer is 10-25 µm.

Another object of the present application aims at providing a deposition process for a solar cell, wherein the thin film mask stated above is used in the deposition process.

Further, the deposition process includes a functional layer deposition process and/or a conductive layer deposition process;
wherein the functional layer deposition includes a dielectric layer deposition; and the conductive layer deposition includes a transparent conductive layer deposition and/or a metal conductive layer deposition.

In conclusion, a thin film mask is provided by the present application, by setting specific optical properties, such as the limitation of the absorption coefficient and the visible light transmittance, for the first layer, a patterning treatment is performed on the first layer by being irradiated by some light sources with specific wavelength ranges, such as the ultraviolet laser, the green laser or the infrared laser. Then, by utilizing that an adhesive film of a second layer has an adhesive characteristic, the patterned thin film mask is adhered to a target object to be treated, and subsequent region pattern manufacturing is performed. The solution of the present application has the following characteristics:

In comparison to the photoresist development, the optical properties are utilized by the thin film mask provided by the present application, the required power of the light source is less and cost can be saved comparing with a common thin film. Furthermore, the patterning content is formed by a light source with low power consumption, and the cost of the adhesive film is low. A complicated process is not needed to be matched with to achieve the patterning process, and cost reduction and efficiency increase are achieved. In addition, comparing with a metal mask, the thin film mask provided by the present application is adhered to the surface of the target object to be treated via the adhesive film, so that the thin film mask is better bonded to the surface. Comparing with the method of the metal mask, the thin film mask is not affected by the hollow region, so that the patterned content is more accurate and the quality is improved.

The above description is only an overview of the technical solution of the present disclosure, in order to be able to better understand the technical means of the present disclosure, and the solution can be implemented in accordance with the content of the description, and in order to make the above and other purposes, features and advantages of the present disclosure more obvious and easy to understand, the following specific embodiments of the present disclosure are hereby given.

### BRIEF DESCRIPTION OF THE DRAWINGS

In order to explain embodiments of the present disclosure or the technical scheme in the prior art more clearly, the drawings required in the description of the embodiments or the prior art will be briefly introduced below; obviously, the drawings in the following description are some embodiments of the present disclosure, and other drawings can be obtained according to these drawings by those of ordinary skill in the art without paying creative labor.
FIG. 1 is a schematic diagram of a structure of a thin film mask of embodiment 1 of the present application;
FIG. 2 is a schematic diagram of a structure of a thin film mask of embodiment 2 of the present application;
FIG. 3 is a schematic diagram of the wavelength and the absorption coefficient of a polymeric membrane using a blue PET thin film material of specific scenario embodiment 1 of the present application;
FIG. 4 is a schematic diagram of the wavelength and the absorption coefficient of a polymeric membrane using a yellow PET thin film material of specific scenario embodiment 2 of the present application;
FIG. 5 is a schematic diagram of the wavelength and the absorption coefficient of a polymeric membrane using a green PO thin film material of specific scenario embodiment 3 of the present application;
FIG. 6 is a schematic diagram of a method for manufacturing an electrode gate line for a solar cell piece of specific application embodiment 1 of the present application;
FIG. 7 is a schematic diagram of a method for manufacturing an electrode gate line for a solar cell piece of specific application embodiment 2 of the present application;
FIG. 8 is a schematic diagram of a method for manufacturing an electrode gate line for a solar cell piece of specific application embodiment 3 of the present application; and
FIG. 9 is a schematic diagram of a method for manufacturing an electrode gate line for a solar cell piece of specific application embodiment 4 of the present application.

### DETAILED DESCRIPTION OF THE EMBODIMENTS

In order to make the purpose, technical solution and advantages of embodiments of the present disclosure clearer, the following will be combined with the accompanying drawings in the embodiments of the present disclosure, the technical solutions in the embodiments of the present disclosure are clearly and completely described, obviously, the described embodiments are a part of the embodiments of the present disclosure, not all embodiments. Based on the embodiments in the present disclosure, all other embodiments obtained by those of ordinary skill in the art without paying creative labor are within the scope of protection of the present disclosure.

In order to make the technical problems, technical solutions and beneficial effects to be solved in the present application more clear, the following combined with the drawings and embodiments, the present application is further explained in detail. It should be understood that the specific embodiments described herein are merely used for explaning the present application and are not used to limit the present application.

The terms "first", "second", "third", "fourth", and the like (if any) in the speicifcation and claims and the above-described figures of the present application, are used for distinguishing between similar objects and not necessarily used for decarving a particular sequence or chronological order. It should be understood that the data used in this way may be interchanged, where appropriate, so that the embodiments of the present application described herein can be implemented in an order other than those illustrated or described herein. Furthermore, the terms "including" and "having", as well as any variations thereof, are intended to cover a non-exclusive inclusion. For example, a process, a method, a system, a product, or a device that includes a list of steps or units is not necessarily limited to those steps or units expressly listed, but may include other steps or units not expressly listed or inherent to these processes, methods, articles, or devices.

The technical solutions of the present disclosure will be described in detail in combination with specific embodiments below. The following specific embodiments may be combined with one another, and the same or similar concepts or processes may not be repeated in some embodiments.

Embodiment 1, a thin film mask with a two-layer laminated structure

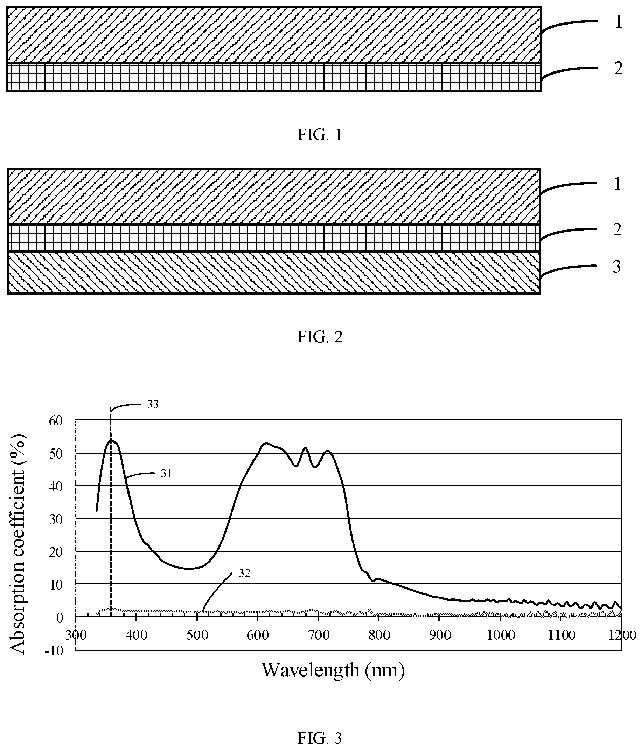

A structure of a thin film mask with a two-layer laminated structure is provided by the embodiment of the present application. FIG. 1 is a schematic diagram of a structure of a thin film mask of embodiment 1 of the present application. As shown in FIG. 1, the structure of the thin film mask includes:
a first layer 1 and a second layer 2, the first layer 1 and the second layer 2 are arranged in layer configuration; and the second layer 2 includes an adhesive film;
under irradiation of an ultraviolet light source and with a thickness of the first layer being 200 µm or less, an absorption coefficient of the first layer 1 is ≥ 20%, wherein a wavelength of the ultraviolet light source is 355 ± 15 nm.

Alternatively, under irradiation of a green light source and with the thickness of the first layer being 200 µm or less, the absorption coefficient of the first layer 1 is ≥ 20%, wherein a wavelength of the green light source is 530 ± 15 nm.

Alternatively, under irradiation of an infrared light source and with the thickness of the first layer being 200 µm or less, the absorption coefficient of the first layer 1 is ≥ 20%, wherein a wavelength of the infrared light source is 1045 ± 20 nm.

A visible light transmittance of the first layer 1 is ≤ 90%.

A thin film mask is provided in the present embodiment, by setting specific optical properties, such as the limitation of the absorption coefficient and the visible light transmittance, for the first layer, a patterning treatment is performed on the first layer by being irradiated by some light sources with specific wavelength ranges, such as the ultraviolet laser, the green laser or the infrared laser. Then, by utilizing that an adhesive film of a second layer has an adhesive characteristic, the patterned thin film mask is adhered to a target object to be treated, and subsequent region pattern manufacturing is performed.

In comparison to the photoresist development, optical properties are utilized by the thin film mask provided by the present application, the required power of the light source is less and cost can be saved comparing with a common thin film. Furthermore, the patterning content is formed by a light source with low power consumption, and the cost of the adhesive film is low. A complicated process is not needed to be matched with to achieve the patterning process, and cost reduction and efficiency increase are achieved. In addition, comparing with a metal mask, the thin film mask provided by the present application is adhered to the surface of the target object to be treated via the adhesive film, so that the thin film mask is better bonded to the surface. Comparing with the method of the metal mask, the thin film mask is not affected by the hollow region, so that the patterned content is more accurate and the quality is improved.

### Embodiment 2, a thin film mask with a three-layer laminated structure

A structure of a thin film mask of a three-layer laminated structure is provided by the embodiment of the present application. FIG. 2 is a schematic diagram of a structure of a thin film mask of embodiment 2 of the present application. As shown in FIG. 2, the structure of the thin film mask includes:
a first layer 1, a second layer 2 and a third layer 3, wherein the first layer 1, the second layer 2 and the third layer 3 are arranged in layer configuration in sequence; the third layer 3 is arranged in layer configuration at a side of the second layer 2 away from the first layer 1; and
the second layer 2 includes an adhesive film and the third layer 3 includes a release film.

Under irradiation of an ultraviolet light source and with a thickness of the first layer being 200 µm or less, an absorption coefficient of the first layer 1 is ≥ 20%, wherein a wavelength of the ultraviolet light source is 355 ± 15 nm.

Alternatively, under irradiation of a green light source and with the thickness of the first layer being 200 µm or less, the absorption coefficient of the first layer 1 is ≥ 20%, wherein a wavelength of the green light source is 530 ± 15 nm.

Alternatively, under irradiation of an infrared light source and with the thickness of the first layer being 200 µm or less, the absorption coefficient of the first layer 1 is ≥ 20%, wherein a wavelength of the infrared light source is 1045 ± 20 nm.

A visible light transmittance of the first layer 1 is ≤ 90%.

The thin film mask provided in the present embodiments, on the basis of the above-mentioned embodiment, further includes a release film, the function of the release film is to, during the patterning machining process of the thin film mask, protect the adhesive film from sticking other stuff during the machining and use, so as to facilitate tearing off the release film after the patterning machining process is completed and sticking the patterned film mask to a target object to be treated.

Some of the features mentioned in the above embodiments are described in further detail below.

Further, under the irradiation of the ultraviolet light source and with the thickness of the first layer being 200 µm or less, the absorption coefficient of the first layer is ≥ 50%; optionally, under the irradiation of the ultraviolet light source and with the thickness of the first layer being 200 µm or less, the absorption coefficient of the first layer is ≥ 80%.

Alternatively, under the irradiation of the green light source and with the thickness of the first layer being 200 µm or less, the absorption coefficient of the first layer is ≥ 50%; optionally, under the irradiation of the green light source and with the thickness of the first layer being 200 µm or less, the absorption coefficient of the first layer is ≥ 80%.

Alternatively, under the irradiation of the infrared light source and with the thickness of the first layer being 200 µm or less, the absorption coefficient of the first layer is ≥ 50%; and optionally, under the irradiation of the infrared light source and with the thickness of the first layer being 200 µm or less, the absorption coefficient of the first layer is ≥ 80%.

In conjunction with the above description, for example, for the ultraviolet light source, the absorption coefficient of the first layer may be 20%, 25%, 30%, 35%, 40%, 45%, 50%, 55%, 60%, 65%, 70%, 75%, 80%, or any range therebetween, with the thickness of the first layer being 200 µm or less.

In conjunction with the above description, for example, for the green light source, the absorption coefficient of the first layer may be 20%, 25%, 30%, 35%, 40%, 45%, 50%, 55%, 60%, 65%, 70%, 75%, 80%, or any range therebetween, with the thickness of the first layer being 200 µm or less.

In conjunction with the above description, for example, for the infrared light source, the absorption coefficient of the first layer is 20%, 25%, 30%, 35%, 40%, 45%, 50%, 55%, 60%, 65%, 70%, 75%, 80%, or any range therebetween, with the thickness of the first layer being 200 µm or less.

Further, the first layer includes a polymeric membrane. The material of the polymeric membrane is a polymer, including one or more of polyethylene glycol terephthalate (PET), polyolefin thin film (PO), polyimide (PI), polyvinyl chloride (PVC), biaxially oriented polypropylene (BOPP), and the like.

In conjunction with the above description, for example, for the visible light transmittance of the first layer is ≤ 90%, the visible light transmittance may be 0%, 5%, 10%, 15%, 20%, 25%, 30%, 35%, 40%, 45%, 50%, 55%, 60%, 65%, 70%, 75%, 80%, 85%, 90%, or any range therebetween.

Further, the thickness of the first layer is 1-100 µm; optionally, the thickness of the first layer is 5-40 µm; and further optionally, a visible light transmittance of the first layer is 10-25 µm.

In connection with the above description, for example, the thickness of the first layer is 1 µm, 5 µm, 10 µm, 15 µm, 20 µm, 25 µm, 30 µm, 35 µm, 40 µm, 45 µm, 50 µm, 55 µm, 60 µm, 65 µm, 70 µm, 75 µm, 80 µm, 85 µm, 90 µm, 95 µm, 100 µm or any range therebetween.

It should be noted here that the feature setting of the absorption coefficient of the first layer with respect to the above-mentioned various light sources may generally be achieved by adjusting the color of the first layer, adding an additive having an absorption characteristic, etc. For example, various dyes, additives, color masterbatches, or other materials are included in the PET film to meet the requirements for the absorption coefficient. For example, black particles are added in a BOPP film, an absorption coefficient of 100% is achieved, and as another example, grey particles are added in a PO film, an absorption coefficient of 50% is achieved.

Further, under the irradiation of the ultraviolet light source and with the thickness of the second layer being 200 µm or less, an absorption coefficient of the adhesive film included by the second layer is ≥ 5%, wherein the wavelength of the ultraviolet light source is 355 ± 15nm. Alternatively, under the irradiation of the green light source and with the thickness of the second layer being 200 µm or less, the absorption coefficient of the second layer is ≥ 5%, wherein the wavelength of the green light source is 530 ± 15 nm. Alternatively, under the irradiation of the infrared light source and with the thickness of the second layer being 200 µm or less, the absorption coefficient of the second layer is ≥ 5%, wherein the wavelength of the infrared light source is 1045 ± 20 nm.

In conjunction with the description above, the wavelength of the ultraviolet light source is 340 nm, 345 nm, 350 nm, 355 nm, 360 nm, 365 nm, 370 nm, or any range therebetween. For example, a laser light source, such as an ultrafast pulsed laser with a pulse width in the order of picoseconds or femtoseconds, or a short pulsed laser with a pulse width in the order of microseconds or nanoseconds, may be used as the ultraviolet light source here.

In conjunction with the description above, the wavelength of the green light source is 515 nm, 520 nm, 525 nm, 530 nm, 535 nm, 540 nm, 545 nm, or any range therebetween. For example, a laser light source, such as an ultrafast pulsed laser with a pulse width in the order of picoseconds or femtoseconds, or a short pulsed laser with a pulse width in the order of microseconds or nanoseconds, may be used as the green light source here.

In conjunction with the above description, the wavelength of the infrared light source is 1025 nm, 1030 nm, 1035 nm, 1040 nm, 1045 nm, 1050 nm, 1055 nm, 1060 nm, 1065 nm, or any range therebetween. For example, a laser light source, such as an ultrafast pulsed laser with a pulse width in the order of picoseconds or femtoseconds, or a short pulsed laser with a pulse width in the order of microseconds or nanoseconds, may be used as the infrared light source here.

Further, a visible light transmittance of the second layer is ≤ 100%. Optionally, the visible light transmittance of the second layer is ≤ 90%.

In conjunction with the above description, for example, for the visible light transmittance of the second layer, the visible light transmittance may be 0%, 5%, 10%, 15%, 20%, 25%, 30%, 35%, 40%, 45%, 50%, 55%, 60%, 65%, 70%, 75%, 80%, 85%, 90%, 95%, 100%, or any range therebetween.

Further, under the irradiation of the ultraviolet light source and with the thickness of the second layer being 200 µm or less, the absorption coefficient of the second layer is ≥ 50%. Optionally, under the irradiation of the ultraviolet light source and with the thickness of the second layer being 200 µm or less, the absorption coefficient of the second layer is ≥ 80%.

The absorption coefficients herein can be referred to the previous description related to absorption coefficients.

Here, it should be noted that, in conjunction with the above description, the thin film mask is required to be designed to have a high absorption rate in a certain wavelength range, so that the energy of the laser may be efficiently absorbed in patterning the thin film mask by using, for example, a laser light source, thereby energy efficiency and patterning accuracy are improved. Particularly, it is required to be designed according to the used laser light source.

Further, a material of an adhesive film included by the second layer includes one or more of silicone, acrylic adhesive, polyurethane, rubber, polyisobutylene, and the like.

Further, the thickness of the second layer is 1-30 µm; optionally, the thickness of the second layer is 2-15 µm; further optionally, the thickness of the second layer is 3-10 µm.

In connection with the above description, for example, the thickness of the second layer is 1 µm, 5 µm, 10 µm, 15 µm, 20 µm, 25 µm, 30 µm or any range therebetween.

Here, the features of the adhesive film are further refined. When the material of the adhesive film includes one or more of silicone gel, acrylic adhesive, polyurethane, rubber, polyisobutylene, etc. A range of a peeling strength of the adhesive film at the first temperature is 1-50 gf/cm; optionally, the range of the peeling strength of the adhesive film at the first temperature is 5-30 gf/cm; and further optionally, the range of the peeling strength of the adhesive film at the first temperature is 6-15 gf/cm. Wherein, the first temperature is 15-30°C. Optionally, the first temperature is 20-30 °C. Further optionally, the first temperature is 20-25 °C.

When the material of the adhesive film includes the unidirectional thermo-sensitive adhesive, the adhesive property of the unidirectional thermo-sensitive adhesive exhibits irreversibility under different temperature conditions. The peeling strength of the unidirectional thermo-sensitive adhesive decreases with the increasing of a temperature. The effect of using the unidirectional thermo-sensitive adhesive here is to better tear off the thin film mask when the temperature is applied.

Specifically, the peeling strength of the unidirectional thermo-sensitive adhesive in the adhesive film of the second layer is 5-30 gf/cm and the temperature is 50-140°C. For example, when the temperature is 50°C, the peeling strength is 25 gf/cm; when the temperature is 70°C, the peeling strength is 21 gf/cm; when the temperature is 100°C, the peeling strength is 15 gf/cm; and when the temperature is 140°C, the peeling strength is 5 gf/cm. It should be noted here that the above data are merely illustrative, and that specific parameter requirements may be corresponded to the requirements in an actual production operation.

When the material of the adhesive film includes a thermal debonding adhesive, the viscidity of the thermal debonding adhesive exhibits irreversibility at a temperature greater than or equal to a second temperature. A peeling strength of the thermal debonding adhesive at a temperature greater than or equal to the second temperature is less than a peeling strength of the thermal debonding adhesive at a temperature less than the second temperature, i.e., the peeling strength of the thermal debonding adhesive may be decreased at the temperature greater than or equal to the second temperature. Optionally, the peeling strength may be decreased rapidly.

Specifically, the second temperature is 70°C. Optionally, the second temperature is 70-150°C. Further optionally, the second temperature is 90-150°C.

When the material of the adhesive film includes the bidirectional thermo-sensitive adhesive, the viscidity of the bidirectional thermo-sensitive adhesive exhibits reversibility under different temperature conditions. The peeling strength of the bidirectional thermo-sensitive adhesive increases with the increasing of the temperature. The effect of using the bidirectional thermo-sensitive adhesive here is to better tear off the thin film mask when the temperature is applied.

Specifically, a peeling strength of the bidirectional thermo-sensitive adhesive in the adhesive film of the second layer is 5 to 30 gf/cm and a temperature is 50-140°C. For example, when the temperature is 50°C, the peeling strength is 5 gf/cm; when the temperature is 80°C, the peeling strength is 15 gf/cm; when the temperature is 110°C, the peeling strength is 20 gf/cm, and when the temperature is 140°C, the peeling strength is 30 gf/cm. It should be noted here that the above data are merely illustrative, and that specific parameter requirements may be corresponded to the requirements in an actual production operation.

In conjunction with the above description, for example, the peeling strength of the adhesive film is 1 gf/cm, 2 gf/cm, 3 gf/cm, 4 gf/cm, 5 gf/cm, 6 gf/cm, 7 gf/cm, 8 gf/cm, 9 gf/cm, 10 gf/cm, 11 gf/cm, 12 gf/cm, 13 gf/cm, 14 gf/cm, 15 gf/cm, 16 gf/cm, 17 gf/cm, 18 gf/cm, 19 gf/cm, 20 gf/cm, 21 gf/cm, 22 gf/cm, 23 gf/cm, 24 gf/cm, 25 gf/cm, 26 gf/cm, 27 gf/cm, 28 gf/cm, 29 gf/cm, 30 gf/cm, 35 gf/cm, 40 gf/cm, 45 gf/cm, 50 gf/cm, 55 gf/cm, 60 gf/cm, 100 gf/cm, 150 gf/cm, 300 gf/cm, 400 gf/cm, 500 gf/cm, 1000 gf/cm, or any range therebetween.

For example, the temperature is 5°C, 10°C, 15°C, 20°C, 25°C, 30°C, 35°C, 40°C, 45°C, 50°C, 55°C, 60°C, 65°C, 70°C, 75°C, 80°C, 85°C, 90°C, 95°C, 100°C, 105°C, 110°C, 115°C, 120°C, 125°C, 130°C, 135°C, 140°C, 145°C, 150°C, 155°C, 160°C, 165°C, 170°C, 175°C, 180°C, 185°C, 190°C, 195°C, 200°C, or any range therebetween.

The adhesive film is required to have a certain peeling strength so that the thin film mask may be firmly adhered to the target object to be treated without curling or warping. For example, under a certain scenario, it is required to work at 20 °C or 25 °C and with a peeling strength being in the range of 15-20 gf/cm. As another example, under another scenario, it is required to work at 80°C and with the peeling strength being in the range of 30-35 gf/cm. In general, the selection of a specific peeling strength may be adjusted accordingly depending on the use scenario and requirements.

Here, with regard to the definition of the peeling strength, the peeling strength test value of the adhesive tape to the steel plate according to the national standard GB/T 2792-2014 of the People's Republic of China may be taken as the identification mode of the peeling strength of the present application. Next, the thickness of the thin film mask of the above embodiments is further illustrated.

Further, the thickness of the thin film mask is 10-100 µm; optionally, the thickness of the thin film mask is 10-50 µm.

Here, considering the thickness of the overall thin film mask, in conjunction with the above description, for example, the thickness of the overall thin film mask is 10 µm, 15 µm, 20 µm, 25 µm, 30 µm, 35 µm, 40 µm, 45 µm, 50 µm, 55 µm, 60 µm, 65 µm, 70 µm, 75 µm, 80 µm, 85 µm, 90 µm, 95 µm, 100 µm or any range therebetween.

For different light sources, such as laser light sources, and the use requirement of thin film mask patterning, the thickness of the overall thin film mask is required to be designed and controlled to match the actual requirements of the light source and patterning.

In general, the selection of the thickness of the overall thin film mask may be adjusted accordingly depending on the use scenario and requirements.

Further, the third layer of the thin film mask includes a release film, the release film is a polymer including one or more of polyethylene glycol terephthalate (PET), polyolefin film (PO), polyimide (PI), polyvinyl chloride (PVC), biaxially oriented polypropylene (BOPP), and the like.

Further, a thickness of the third layer is 1-100 µm; optionally, the thickness of the third layer is 5-40 µm; and further optionally, the thickness of the third layer is 10-25 µm.

In connection with the above description, for example, the thickness of the third layer is 1 µm, 5 µm, 10 µm, 15 µm, 20 µm, 25 µm, 30 µm, 35 µm, 40 µm, 45 µm, 50 µm, 55 µm, 60 µm, 65 µm, 70 µm, 75 µm, 80 µm, 85 µm, 90 µm, 95 µm, 100 µm, or any range therebetween.

The thin film mask described above may be applied in the deposition process of solar cells.

Further, the deposition process includes a functional layer deposition process and/or a conductive layer deposition process. The thin film mask may alternatively or both be used in the manufacturing process of the functional layer and the conductive layer. Herein, the functional layer deposition includes dielectric layer deposition. The conductive layer deposition includes a transparent conductive layer deposition and/or a metal conductive layer deposition.

The dielectric layers described above include one or more of a passivation layer, an insulating layer, an antireflective layer, and the like.

### Specific scenario embodiment 1

The thin film mask is composed of a laminated layer of a polymeric membrane and an adhesive film.

The 5 µm blue PET thin film material is used as the polymeric membrane, and the specific parameters of the polymeric membrane using the 5 µm blue PET thin film material are that: the visible light transmittance is ≤ 90%, and the energy absorption coefficient of the polymeric membrane for the ultraviolet light with the wavelength of 355 nm ≥ 50%. FIG. 3 is a schematic diagram of the wavelength and the absorption coefficient of a polymeric membrane using a blue PET thin film material of specific scenario embodiment 1 of the present application. As shown in FIG. 3, the abscissa is the numerical range of wavelengths in nm, and the ordinate is the absorption coefficient in %. In FIG. 3, 31 represents the absorption coefficient of the polymeric membrane using the blue PET thin film material in different wavelength ranges. In FIG. 3, 32 represents the absorption coefficient of the polymeric membrane using the transparent PET thin film material in different wavelength ranges. It may be seen that the energy absorption coefficient of the polymeric membrane, using the blue PET thin film material, at a wavelength of 355 nm of the ultraviolet light is 53%, as shown by 33 in FIG. 3.

The adhesive film is a silicone adhesive with the thickness of 5 µm, and the specific parameters of the adhesive film are that: the visible light transmittance is ≤ 90%, the energy absorption coefficient of the adhesive film for the ultraviolet light with the wavelength being 355 nm is ≥ 5%, and the peeling strength is 10-15 gf/cm at 25°C.

### Specific scenario embodiment 2

The thin film mask is composed of a laminated layer of a polymeric membrane and an adhesive film.

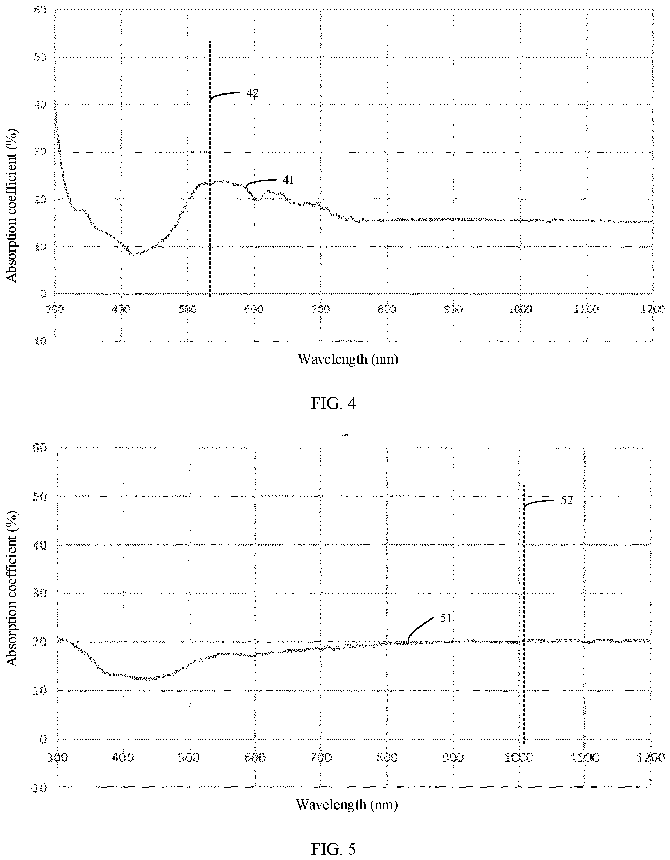

The 10 µm yellow PET thin film material is used as the polymeric membrane, and the specific parameters of the polymeric membrane using the 10 µm yellow PET thin film material are that: the visible light transmittance ≤ 40%, and the energy absorption coefficient of the polymeric membrane for the green light with the wavelength being 530 nm is ≥ 20%. FIG. 4 is a schematic diagram of the wavelength and the absorption coefficient of the polymeric membrane using a yellow PET thin film material of specific scenario embodiment 2 of the present application. As shown in FIG. 4, the abscissa is the numerical range of wavelengths in nm, and the ordinate is the absorption coefficient in %.In FIG. 4, 41 represents the absorption coefficient of the polymeric membrane using the yellow PET thin film material in different wavelength ranges. It can be seen that the energy absorption coefficient of the polymeric membrane, using a yellow PET thin film material, at the wavelength of 530 nm of the green light is 23%, as shown by 42 in FIG. 4.

The adhesive film is a silicone adhesive with the thickness of 7 µm, and the specific parameters of the adhesive film are that: the visible light transmittance is ≤ 40%, the energy absorption coefficient of the adhesive film for the green light with the wavelength being 530 nm is ≥ 35%, and the peeling strength is 20-25 gf/cm at 25°C.

### Specific scenario embodiment 3

The thin film mask is composed of a laminated layer of a polymeric membrane and an adhesive film.

The 15 µm green PO thin film material is used as the polymeric membrane, and the specific parameters of the polymeric membrane using the 15 µm green PET thin film material are that: the visible light transmittance is ≤ 80%, and the energy absorption coefficient of the polymeric membrane for the infrared light with the wavelength being 1065 nm is ≥ 20%. FIG. 5 is a schematic diagram of the wavelength and the absorption coefficient of a polymeric membrane using a green PO thin film material of specific scenario embodiment 3 of the present application. As shown in FIG. 5, the abscissa is the numerical range of wavelengths in nm, and the ordinate is the absorption coefficient in %. In FIG. 5, 51 represents the absorption coefficient of the polymeric membrane using the green PO film material in different wavelength ranges. It can be seen that the energy absorption coefficient of the polymeric membrane, using the green PO thin film material, at the wavelength of 1065 nm of the infrared light is 20% , as shown by 52 in FIG. 5.

The adhesive film is a silicone adhesive with the thickness of 10 µm, and the specific parameters of the adhesive film are that: the visible light transmittance is ≤ 80%, the energy absorption coefficient of the adhesive film for the infrared light with the wavelength being 1065 nm is ≥ 25%, and the peeling strength is 10-15 gf/cm at 20°C.

### Specific scenario embodiment 4

The thin film mask is composed of a laminated layer of a polymeric membrane and an adhesive film.

The 5 µm brown PI thin film material is used as the polymeric membrane, and the specific parameters of the polymeric membrane using the 5 µm brown PI thin film material are that: the visible light transmittance is ≤ 80%, and the energy absorption coefficient of the polymeric membrane for the ultraviolet light with the wavelength being 355 nm is ≥ 20%.

The adhesive film is a silicone adhesive with the thickness of 5 µm, and the specific parameters of the adhesive film are that: the visible light transmittance is ≤ 80%, the energy absorption coefficient of the adhesive film for the ultraviolet light with the wavelength being 355 nm is ≥ 20%, and the peeling strength is 15-20 gf/cm at 20°C.

### Specific scenario embodiment 5

The thin film mask is composed of a laminated layer of a polymeric membrane and an adhesive film.

The 10 µm blue PVC thin film material is used as the polymeric membrane, and the specific parameters of the polymeric membrane using the 10 µm blue PVC thin film material are that: the visible light transmittance is ≤ 70%, and the energy absorption coefficient of the polymeric membrane for the ultraviolet light with the wavelength being 343 nm is ≥ 40%.

The adhesive film is a acrylic adhesive with the thickness of 7 µm, and the specific parameters of the adhesive film are that: the visible light transmittance is ≤ 80%, the energy absorption coefficient of the adhesive film for the ultraviolet light with the wavelength being 343 nm is ≥ 30%, and the peeling strength is 20-25 gf/cm at 20°C.

### Specific scenario embodiment 6

The thin film mask is composed of a laminated layer of a polymeric membrane and an adhesive film.

The 20 µm brown BOPP thin film material is used as the polymeric membrane, and the specific parameters of the polymeric membrane using the 20 µm brown BOPP thin film material are that: the visible light transmittance is ≤ 80%, and the energy absorption coefficient of the polymeric membrane for the infrared light with the wavelength being 1030 nm is ≥ 15%.

The adhesive film is a polyurethane adhesive with the thickness of 15 µm, and the specific parameters of the adhesive film are that: the visible light transmittance is ≤ 90%, the energy absorption coefficient of the adhesive film for the infrared light with the wavelength being 1030 nm is ≥ 20%, and the peeling strength is 25-30 gf/cm at 20°C.

### Specific scenario embodiment 7

The thin film mask is composed of a laminated layer of a polymeric membrane and an adhesive film.

The 5 µm blue PET thin film material is used as the polymeric membrane, and the specific parameters of the polymeric membrane using the 5 µm blue PET thin film material are that: the visible light transmittance is ≤ 90%, and the energy absorption coefficient of the polymeric membrane for the ultraviolet light with the wavelength being 355 nm is ≥ 20%.

The adhesive film is a unidirectional thermo-sensitive adhesive with the thickness of 5 µm, and the specific parameters of the adhesive film are that: the visible light transmittance is ≤ 73%, the energy absorption coefficient of the adhesive film for the ultraviolet light with the wavelength being 355 nm is ≥ 10%, and the peeling strength is 20-25 gf/cm at 15-25°C; the peeling strength is 20-30 gf/cm at 50-100°C ; and the peeling strength is 5-7 gf/cm at 140°C.

### Specific scenario embodiment 8

The thin film mask is composed of a laminated layer of a polymeric membrane and an adhesive film.

The 8 µm red PO thin film material is used as the polymeric membrane, and the specific parameters of the polymeric membrane using the 8 µm red PO thin film material are that: the visible light transmittance is ≤ 43%, and the energy absorption coefficient of the polymeric membrane for the green light with the wavelength being 545 nm is ≥ 36%.

The adhesive film is a unidirectional thermo-sensitive adhesive with the thickness of 7 µm, and the specific parameters of the adhesive film are that: the visible light transmittance is ≤ 32%, the energy absorption coefficient of the adhesive film for the green light with the wavelength being 545 nm is ≥ 41%, and the peeling strength is 23-25 gf/cm at 20-30°C; the peeling strength is 17-24 gf/cm at 60-110°C; and the peeling strength is 5-6 gf/cm at 130°C.

### Specific scenario embodiment 9

The thin film mask is composed of a laminated layer of a polymeric membrane and an adhesive film.

The 6 µm blue PET thin film material is used as the polymeric membrane, and the specific parameters of the polymeric membrane using the 6 µm blue PET thin film material are that: the visible light transmittance is ≤ 80%, and the energy absorption coefficient of the polymeric membrane for the ultraviolet light with the wavelength being 350 nm is ≥ 25%.

The adhesive film is a bidirectional thermo-sensitive adhesive with the thickness of 6 µm, and the specific parameters of the adhesive film are that: the visible light transmittance is ≤ 61%, the energy absorption coefficient of the adhesive film for the ultraviolet light with the wavelength being 350 nm is ≥ 5%, and the peeling strength is 5-7 gf/cm at 50°C; the peeling strength is 15-21 gf/cm at 80-100°C ; and the peeling strength is 26-30 gf/cm at 120-140°C.

### Specific scenario embodiment 10

The thin film mask is composed of a laminated layer of a polymeric membrane and an adhesive film.

The 10 µm red BOPP thin film material is used as the polymeric membrane, and the specific parameters of the polymeric membrane using the 10 µm red BOPP thin film material are that: the visible light transmittance is ≤ 75%, and the energy absorption coefficient of the polymeric membrane for the green light with the wavelength being 520 nm is ≥ 45%.

The adhesive film is a bidirectional thermo-sensitive adhesive with the thickness of 8 µm, and the specific parameters of the adhesive film are that: the visible light transmittance is ≤ 49%, the energy absorption coefficient of the adhesive film for the green light with the wavelength being 520 nm is ≥ 12%, and the peeling strength is 6-10 gf/cm at 55°C; the peeling strength is 12-19 gf/cm at 70-90°C; and the peeling strength is 20-25 gf/cm at 100-130°C.

### Specific scenario embodiment 11

The thin film mask is composed of a laminated layer of a polymeric membrane, an adhesive film and a release film.

The 8 µm blue PVC thin film material is used as the polymeric membrane, and the specific parameters of the polymeric membrane using the 8 µm blue PVC thin film material are that: the visible light transmittance is ≤ 80%, and the energy absorption coefficient of the polymeric membrane for the ultraviolet light with the wavelength being 340 nm is ≥ 30%.

The adhesive film is a silicone adhesive with the thickness of 9 µm, and the specific parameters of the adhesive film are that: the visible light transmittance is ≤ 8%, the energy absorption coefficient of the adhesive film for the ultraviolet light with the wavelength being 340 nm is ≥ 34%, and the peeling strength is 16-18 gf/cm at 25°C.

The release film is a transparent PET film with the thickness of 5 µm.

### Specific scenario embodiment 12

The thin film mask is composed of a laminated layer of a polymeric membrane, an adhesive film and a release film.

The 10 µm green PO thin film material is used as the polymeric membrane, and the specific parameters of the polymeric membrane using the 10 µm green PO thin film material are that: the visible light transmittance is ≤ 48%, and the energy absorption coefficient of the polymeric membrane for the infrared light with the wavelength being 1065 nm is ≥ 39%.

The adhesive film is a silicone adhesive with the thickness of 8 µm, and the specific parameters of the adhesive film are that: the visible light transmittance is ≤ 31%, the energy absorption coefficient of the adhesive film for the infrared light with the wavelength being 1065 nm is ≥ 31%, and the peeling strength is 10-15 gf/cm at 25°C.

The release film is a transparent PET film with the thickness of 5 µm.

Specific application embodiments of the thin film mask are shown below, and are applied in the field of manufacturing the solar cell piece, and are specifically applied in the process of manufacturing an electrode gate line.

### Specific application embodiment 1

Here, the features of the thin film mask specifically used are that: the thin film mask is composed of a laminated layer of a polymeric membrane and an adhesive film; the 5 µm blue PET thin film is used as the polymeric membrane, the visible light transmittance of the polymeric membrane is ≤ 73%, and the energy absorption coefficient of the polymeric membrane for the ultraviolet light with the wavelength being 350 nm is ≥ 47%. The adhesive film is a silicone adhesive with the thickness of 5 µm, the visible light transmittance of the silicone adhesive is ≤ 54%, the energy absorption coefficient of the adhesive film for the ultraviolet light with the wavelength being 350 nm is ≥ 24%, and the peeling strength of the adhesive film is 10-15 gf/cm at 25 °C.

By using the polymeric membrane and the adhesive film with the specially set optical properties, the energy absorptions of the polymeric membrane and the adhesive film are better in the wavelength range of the ultraviolet light. When an ultraviolet laser is used to carve a thin film mask to form a patterned content, the power requirement of the ultraviolet laser is small, and costs may be saved.

In addition, with regard to the peeling strength range of the adhesive film, an appropriate numerical range is adopted, so that the adhesion of the thin film mask meets the processing requirements, the thin film mask cannot be too loose or too sticky. That is to say, the thin film mask can not fall off during the process of manufacturing the electrode gate lines, and the solar cell piece may also not be damaged during the process of tearing off the film after the electrode gate lines are manufactured.

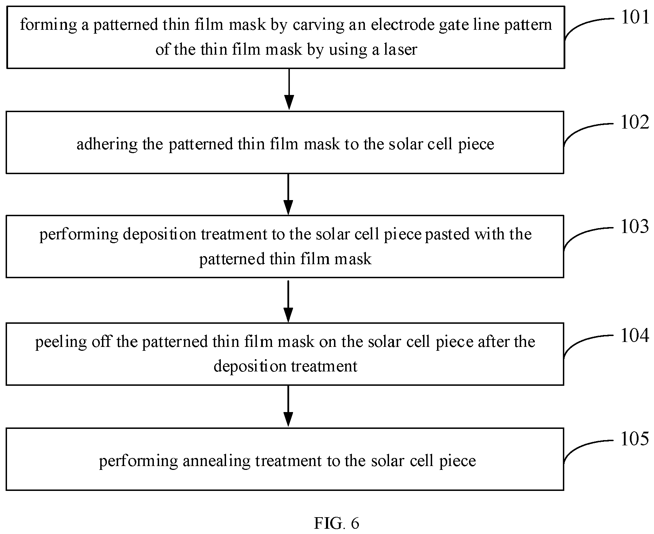

FIG. 6 is a schematic diagram of a method for manufacturing an electrode gate line for a solar cell piece of specific application embodiment 1 of the present application. As shown in FIG. 6, the specific method in the present embodiment includes the steps as follows:
S101, forming a patterned thin film mask by carving an electrode gate line pattern of the thin film mask by using a laser.

Firstly, a designed pattern is carved on a thin film mask by using the laser etching process. A picosecond ultraviolet light source with a wavelength of 350 nm is used by the laser. Optionally, the width of the pattern is 1 µm-500 µm; further optionally, the width of the pattern is 1 µm-20 µm. The spacing of the pattern line is 50 µm-5 mm; further optionally, the spacing of the pattern line is 500 µm-2 mm. It should be noted here that the pattern designed on the thin film mask is an electrode gate line pattern on a subsequent solar cell piece. In addition, the selection of the width of the pattern and the line spacing of the pattern may be adjusted accordingly depending on the use scenario and requirements.

S102, adhering the patterned thin film mask to the solar cell piece.

Next, the thin film mask with the carved electrode gate line pattern is adhered to a surface of the solar cell piece on which the electrode gate line needs to be disposed, i.e., a surface of the silicone adhesive of the thin film mask exposed to the outside is adhered to the solar cell piece.

S103, performing deposition treatment to the solar cell piece pasted with the patterned thin film mask.

Next, the solar cell piece pasted with the patterned thin film mask is subjected to the deposition treatment. Specifically, the metal electrode gate lines are manufactured by using the method of the physical vapor deposition (PVD), or the electrode gate lines are manufactured on the solar cell piece by using the method of electroplating. Wherein, the PVD method and the electroplating method are well-known techniques and may not be described in detail herein.

S104, peeling off the patterned thin film mask on the solar cell piece after the deposition treatment.

Then, the patterned thin film mask on the solar cell piece after the deposition treatment is peeled off. The electrode gate lines are not formed in the covered regions on the solar cell piece, and the electrode gate lines are formed on the uncovered regions on the solar cell piece.

S105, performing annealing treatment to the solar cell piece.

Finally, the solar cell piece forming the patterned electrode gate lines is annealed to complete the manufacturing of the electrode gate lines.

### Specific application embodiment 2

Here, the features of the thin film mask specifically used are that: the thin film mask is composed of a laminated layer of a polymeric membrane, an adhesive film and a release film; the 10µm red BOPP thin film is used as the polymeric membrane, the visible light transmittance of the polymeric membrane is ≤ 48% and an energy absorption coefficient of the polymeric membrane for the green light with the wavelength being 530nm is ≥ 31%. The adhesive film is a silicone adhesive with the thickness of 3 µm, the visible light transmittance of the adhesive film is ≤ 61%, the energy absorption coefficient of the adhesive film for the green light with the wavelength being 530nm is ≥ 32%, and the peeling strength of the adhesive film is 16-21 gf/cm at 20°C. The release film is a transparent PET film with the thickness of 10 µm.

By using the polymeric membrane and the adhesive film with the specially set optical properties, the energy absorptions of the polymeric membrane and the adhesive film are better in the wavelength range of the green light. When a green laser is used to carve a thin film mask to form a patterned content, the power requirement of the green laser is small, and costs may be saved.

In addition, with regard to the peeling strength range of the adhesive film, an appropriate numerical range is adopted, so that the adhesion of the thin film mask meets the processing requirements, the thin film mask cannot be too loose or too sticky. That is to say, the thin film mask can not fall off during the process of manufacturing the electrode gate lines, and the solar cell piece may also not be damaged during the process of tearing off the film after the electrode gate lines are manufactured.

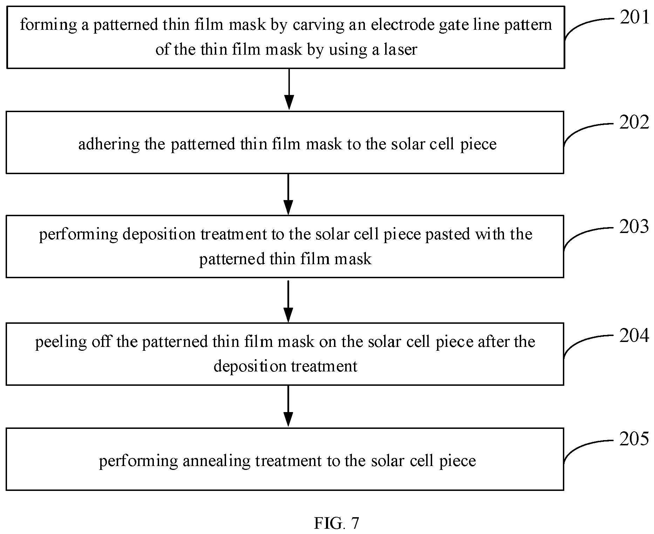

FIG. 7 is a schematic diagram of a method for manufacturing an electrode gate line for a solar cell piece of specific application embodiment 2 of the present application. As shown in FIG. 7, the specific method in the present embodiment includes the steps as follows:

S201, forming a patterned thin film mask by carving an electrode gate line pattern of the thin film mask by using a laser.

Firstly, a designed pattern is carved on a thin film mask by using the laser etching process. A picosecond green light source with a wavelength of 530 nm is used by the laser. Optionally, the width of the pattern is 1 µm-500 µm; further optionally, the width of the pattern is 1 µm-20 µm. The spacing of the pattern line is 50 µm-5 mm; further optionally, the spacing of the pattern line is 500 µm-2 mm. It should be noted here that the pattern designed on the thin film mask is an electrode gate line pattern on a subsequent solar cell piece. In addition, the selection of the width of the pattern and the line spacing of the pattern may be adjusted accordingly depending on the use scenario and requirements.

S202, adhering the patterned thin film mask to the solar cell piece.

Next, after the release film of the thin film mask with the carved electrode gate line pattern is teared off, the thin film mask is adhered to a surface of the solar cell piece on which the electrode gate line needs to be disposed, i.e., a surface of the silicone adhesive of the thin film mask exposed to the outside is adhered to the solar cell piece.

S203, performing deposition treatment to the solar cell piece pasted with the patterned thin film mask.

Next, the solar cell piece pasted with the patterned thin film mask is subjected to the deposition treatment. Specifically, the metal electrode gate lines are manufactured by using the method of the physical vapor deposition (PVD), or the electrode gate lines are manufactured on the solar cell pieces by using the method of electroplating. Wherein, the PVD method and the electroplating method are well-known techniques and may not be described in detail herein.

S204, peeling off the patterned thin film mask on the solar cell piece after the deposition treatment.

Then, the patterned thin film mask on the solar cell piece after the deposition treatment is peeled off. The electrode gate lines are not formed in the covered regions on the solar cell piece, and the electrode gate lines are formed in the uncovered regions on the solar cell piece.

S205, performing annealing treatment to the solar cell piece.

Finally, the solar cell piece forming the patterned electrode gate lines is annealed to complete the manufacturing of the electrode gate lines.

### Specific application embodiment 3

Here, the features of the thin film mask specifically used are that: the thin film mask is composed of a laminate layer of a polymeric membrane and an adhesive film; the 15 µm blue PO thin film material is used as the polymeric membrane, the visible light transmittance of the polymeric membrane is ≤ 62%, and the energy absorption coefficient of the polymeric membrane for the ultraviolet light with the wavelength being 355 nm is ≥ 58%. The adhesive film is a unidirectional thermo-sensitive adhesive with the thickness of 10 µm, the visible light transmittance of the adhesive film is ≤ 75%, and the energy absorption coefficient of the adhesive film for the ultraviolet light with the wavelength being 355 nm is ≥ 24%, and the peeling strength of the adhesive film is 35 gf/cm at 20°C; the peeling strength of the adhesive film is 20-30 gf/cm at 50-85 °C ; and the peeling strength of the adhesive film is 5 gf/cm at 140°C .

By using the polymeric membrane and the adhesive film with the specially set optical properties, the energy absorptions of the polymeric membrane and the adhesive film are better in the wavelength range of the ultraviolet light. When a ultraviolet laser is used to carve a thin film mask to form a patterned content, the power requirement of the ultraviolet laser is small, and costs may be saved.

In addition, with regard to the peeling strength range of the adhesive film, an appropriate numerical range is adopted, so that the adhesion of the thin film mask meets the processing requirements, the thin film mask cannot be too loose or too sticky. That is to say, the thin film mask can not fall off during the process of manufacturing the electrode gate lines, and the solar cell piece may also not be damaged during the process of tearing off the film after the electrode gate lines are manufactured.

S301, forming a patterned thin film mask by carving an electrode gate line pattern of the thin film mask by using a laser.

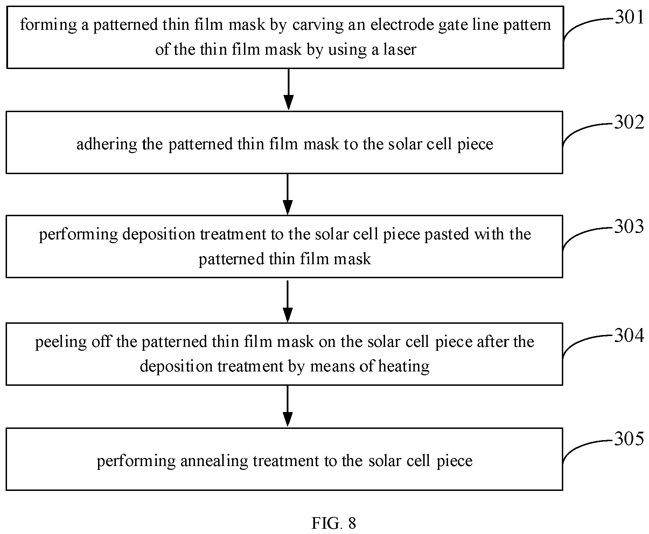

FIG. 8 is a schematic diagram of a method for manufacturing an electrode gate line for a solar cell piece of specific application embodiment 3 of the present application. As shown in FIG. 8, the specific method in the present embodiment includes the steps as follows:
Firstly, a designed pattern is carved on a thin film mask by using the laser etching process. A picosecond ultraviolet light source with a wavelength of 350 nm is used by the laser. Optionally, the width of the pattern is 1 µm-500 µm; further optionally, the width of the pattern is 1 µm-20 µm. The spacing of the pattern line is 50 µm-5 mm, further optionally, the spacing of the pattern line is 500 µm-2 mm. It should be noted here that the pattern designed on the thin film mask is an electrode gate line pattern on a subsequent solar cell piece. In addition, the selection of the width of the pattern and the line spacing of the pattern may be adjusted accordingly depending on the use scenario and requirements.

S302, adhering the patterned thin film mask to the solar cell piece.

Next, the thin film mask with the carved electrode gate line pattern is adhered to a surface of the solar cell piece on which the electrode gate line needs to be disposed, i.e., a surface of the unidirectional thermo-sensitive adhesive of the thin film mask exposed to the outside is adhered to the solar cell piece.

S303, performing a deposition treatment to the solar cell piece pasted with the patterned thin film mask.

Next, the solar cell piece pasted with the patterned thin film mask is subjected to the deposition treatment. Specifically, the metal electrode gate lines are manufactured by using the method of the physical vapor deposition (PVD), or the electrode gate lines are manufactured on the solar cell pieces by using the method of electroplating. Wherein, the PVD method and the electroplating method are well-known techniques and may not be described in detail herein.

S304, peeling off the patterned thin film mask on the solar cell piece after the deposition treatment by means of heating.

Then, by heating the solar cell piece after the deposition treatment, for example, the heating is performed by using the hot filament at 150°C for 5 minutes, or by using the infrared lamp at 150 °C for 10 minutes. Since the peeling strength of the unidirectional thermo-sensitive adhesive at 150 °C is weakened comparing with the peeling strength at a room temperature, it is relatively easy to peel off the patterned thin film mask on the solar cell piece after the deposition treatment. Finally, the electrode gate lines are not formed on the covered regions on the solar cell piece, and the electrode gate lines are formed on the uncovered regions on the solar cell piece.

S305, performing annealing treatment to the solar cell piece.

Finally, the solar cell piece forming the patterned electrode gate lines is annealed to complete the manufacturing of the electrode gate lines.

### Specific application embodiment 4

Here, the features of the thin film mask specifically used are that: the thin film mask is composed of a laminated layer of a polymeric membrane and an adhesive film laminate; the 20 µm green PVC thin film is used as the polymeric membrane, the visible light transmittance of the polymeric membrane is ≤ 58%, and the energy absorption coefficient of the polymeric membrane for the green light with the wavelength being 547 nm is ≥ 39%. The adhesive film is a bidirectional thermo-sensitive adhesive with the thickness of 15 µm, the visible light transmittance of the adhesive film is ≤ 41%, the energy absorption coefficient of the adhesive film for the green light with the wavelength being 547 nm is ≥ 65%, and the peeling strength of the adhesive film is 5 gf/cm at 25°C; the peeling strength of the adhesive film is 17-22 gf/cm at 50-80°C and the peeling strength of the adhesive film is 27-30 gf/cm at 120-140°C.

By using the polymeric membrane and the adhesive film with the specially set optical properties, the energy absorptions of the polymeric membrane and the adhesive film are better in the wavelength range of the green light. When a green laser is used to carve a thin film mask to form a patterned content, the power requirement of the green laser is small, and costs may be saved.

In addition, with regard to the peeling strength range of the adhesive film, an appropriate numerical range is adopted, so that the adhesion of the thin film mask meets the processing requirements, the thin film mask cannot be too loose or too sticky. That is to say, the thin film mask can not fall off during the process of manufacturing the electrode gate lines, and the solar cell piece may also not be damaged during the process of tearing off the film after the electrode gate lines are manufactured.

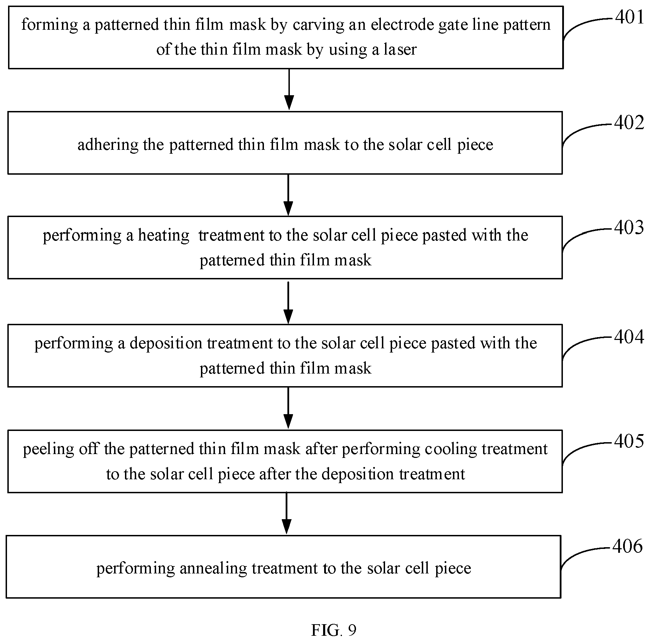

FIG. 9 is a schematic diagram of a method for manufacturing an electrode gate line for a solar cell piece of specific application embodiment 4 of the present application. As shown in FIG. 9, the specific method in the present embodiment includes the steps as follows:
S401, forming a patterned thin film mask by carving an electrode gate line pattern of the thin film mask by using a laser.

Firstly, a designed pattern is carved on a thin film mask by usig the laser etching process. A picosecond ultraviolet light source with a wavelength of 547 nm is used by the laser. Optionally, the width of the pattern is 1 µm-500 µm; further optionally, the width of the pattern is 1 µm-20 µm. The spacing of the pattern line is 50 µm-5 mm, further optionally, the spacing of the pattern line is 500 µm-2 mm. It should be noted here that the pattern designed on the thin film mask is an electrode gate line pattern on a subsequent solar cell piece. In addition, the selection of the width of the pattern and the line spacing of the pattern may be adjusted accordingly depending on the use scenario and requirements.

S402, adhering the patterned thin film mask to the solar cell piece.

Next, the thin film mask with the carved electrode gate line pattern is adhered to a surface of the solar cell piece on which the electrode gate line needs to be disposed, i.e., a surface of the bidirectional thermo-sensitive adhesive of the thin film mask exposed to the outside is adhered to the solar cell piece.

S403, performing a heating treatment to the solar cell piece pasted with the patterned thin film mask.

The solar cell piece pasted with the patterned thin film mask is heated by means of heating, the peeling strength of the bidirectional thermo-sensitive adhesive increases with the increasing of the temperature, so that the patterned thin film mask and the solar cell piece are adhered more firmly by means of heating, so as to facilitate the processing and treatment of subsequent processes. The method of heating is achieved by means of, for example, heating at 130°C for 2 minutes by using a hot filament, or heating at 70 °C for 5 minutes by using an infrared lamp, etc.

S404, performing a deposition treatment to the solar cell piece pasted with the patterned thin film mask.

Next, the solar cell piece pasted with the patterned thin film mask is subjected to the deposition treatment. Specifically, the metal electrode gate lines are manufactured by using the method of the physical vapor deposition (PVD), or the electrode gate lines are manufactured on the solar cell pieces by using the method of electroplating. Wherein, the PVD method and the electroplating method are well-known techniques and may not be described in detail herein.

S405, peeling off the patterned thin film mask after performing cooling treatment to the solar cell piece after the deposition treatment.

Then, since the bidirectional thermo-sensitive adhesive has reversibility, namely, the peeling strength increases with the increasing of a temperature, and the peeling strength decreases with the decreasing of a temperature. Thus, by reducing the temperature of the solar cell piece after the deposition treatment, namely, after the cooling treatment, it is relatively easy to peel off the patterned thin film mask on the solar cell piece after the deposition treatment. Finally, the electrode gate lines are not formed in the covered regions on the solar cell piece, and the electrode gate lines are formed in the uncovered regions on the solar cell piece.

S406, performing annealing treatment to the solar cell piece.

Finally, the solar cell piece forming the patterned electrode gate lines is annealed to complete the manufacturing of the electrode gate lines.

In the above description of embodiments, the specific features, structures, materials or characteristics may be combined in any one or more embodiments or examples in a suitable manner.

The foregoing descriptions are merely detailed embodiments of the present disclosure, but the protection scope of the present disclosure is not limited thereto. Any changes or substitutions that can be easily thought of by those familiar with the technical field within the technical scope disclosed in the present disclosure should be covered by the protection scope of the present disclosure. Therefore, the protection scope of the present disclosure should be subjected to the protection scope of the claims.

Finally, it should be noted that the above embodiments are merely intended to explain the technical solutions of the present application, and not to limit them. Although the present application is explained in detail with reference to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present application.

## Claims

1. A thin film mask, **characterized in that** the thin film mask comprises a first layer and a second layer; the first layer and the second layer are arranged in layer configuration; and the second layer comprises an adhesive film;
under irradiation of an ultraviolet light source and with a thickness of the first layer being 200 µm or less, an absorption coefficient of the first layer is ≥ 20%, wherein a wavelength of the ultraviolet light source is 355 ± 15 nm; or under irradiation of a green light source and with the thickness of the first layer being 200 µm or less, the absorption coefficient of the first layer is ≥ 20%, wherein a wavelength of the green light source is 530 ± 15 nm; or under irradiation of an infrared light source and with the thickness of the first layer being 200 µm or less, the absorption coefficient of the first layer is ≥ 20%, wherein a wavelength of the infrared light source is 1045 ± 20 nm; and
a visible light transmittance of the first layer is ≤ 90%.

2. The thin film mask according to claim 1, wherein under the irradiation of the ultraviolet light source and with the thickness of the first layer being 200 µm or less, the absorption coefficient of the first layer is ≥ 50%; optionally, under the irradiation of the ultraviolet light source and with the thickness of the first layer being 200 µm or less, the absorption coefficient of the first layer is ≥ 80%; or
under the irradiation of the green light source and with the thickness of the first layer being 200 µm or less, the absorption coefficient of the first layer is ≥ 50%; optionally, under the irradiation of the green light source and with the thickness of the first layer being 200 µm or less, the absorption coefficient of the first layer is ≥ 80%; or
under the irradiation of the infrared light source and with the thickness of the first layer being 200 µm or less, the absorption coefficient of the first layer is ≥ 50%; and optionally, under the irradiation of the infrared light source and with the thickness of the first layer being 200 µm or less, the absorption coefficient of the first layer is ≥ 80%.

3. The thin film mask according to claim 1, wherein the first layer comprises a polymeric membrane;
a material of the polymeric membrane is a polymer, comprising one or more of polyethylene glycol terephthalate, polyolefin thin film, polyimide, polyvinyl chloride, and biaxially oriented polypropylene.

4. The thin film mask according to claim 1, wherein the thickness of the first layer is 1-100 µm; optionally, the thickness of the first layer is 5-40 µm; and further optionally, the thickness of the first layer is 10-25 µm.

5. The thin film mask according to claim 1, wherein under the irradiation of the ultraviolet light source and with a thickness of the second layer being 200 µm or less, an absorption coefficient of the second layer is ≥ 5%, wherein the wavelength of the ultraviolet light source is 355 ± 15nm; or under the irradiation of the green light source and with the thickness of the second layer being 200 µm or less, the absorption coefficient of the second layer is ≥ 5%, wherein the wavelength of the green light source is 530 ± 15nm; or, under the irradiation of the infrared light source and with the thickness of the second layer being 200 µm or less, the absorption coefficient of the second layer is ≥ 5%, wherein the wavelength of the infrared light source is 1045 ± 20 nm.

6. The thin film mask according to claim 1, wherein under the irradiation of the ultraviolet light source and with a thickness of the second layer being 200 µm or less, an absorption coefficient of the second layer is ≥ 50%; optionally, under the irradiation of the ultraviolet light source and with the thickness of the second layer being 200 µm or less, the absorption coefficient of the second layer is ≥ 80%; or
under the irradiation of the green light source and with the thickness of the second layer being 200 µm or less, the absorption coefficient of the second layer is ≥ 50%; optionally, under the irradiation of the green light source and with the thickness of the second layer being 200 µm or less, the absorption coefficient of the second layer is ≥ 80%; or
under the irradiation of the infrared light source and with the thickness of the second layer being 200 µm or less, the absorption coefficient of the second layer is ≥ 50%; and optionally, under the irradiation of the infrared light source and with the thickness of the second layer being 200 µm or less, the absorption coefficient of the second layer is ≥ 80%.

7. The thin film mask according to claim 1, wherein a thickness of the second layer is 1-30 µm; optionally, the thickness of the second layer is 2-15 µm; and further optionally, the thickness of the second layer is 3-10 µm.

8. The thin film mask according to claim 1, wherein a material of the adhesive film in the second layer comprises one or more of silicone, acrylic adhesive, polyurethane, rubber, and polyisobutylene.

9. The thin film mask according to claim 8, wherein a peeling strength of the second layer at a first temperature is 1-50 gf/cm; optionally, the peeling strength of the second layer is 5-30 gf/cm; and further optionally, the peeling strength of the second layer is 6-15 gf/cm;
wherein the first temperature is 15-30°C; optionally, the first temperature is 20-30°C; further optionally, the first temperature is 20-25 °C.

10. The thin film mask according to claim 1, wherein a material of the adhesive film in the second layer comprises a unidirectional thermo-sensitive adhesive, a viscosity of the unidirectional thermo-sensitive adhesive exhibits irreversibility under different temperature conditions; and
a peeling strength of the unidirectional thermo-sensitive adhesive decreases with increasing of a temperature.

11. The thin film mask according to claim 1, wherein a material of the adhesive film in the second layer comprises a thermal debonding adhesive, a viscidity of the thermal debonding adhesive exhibits irreversibility at a temperature greater than or equal to a second temperature; and
a peeling strength of the thermal debonding adhesive at the temperature greater than or equal to the second temperature is less than a peeling strength of the thermal debonding adhesive at a temperature less than the second temperature;
wherein the second temperature is 70°C; optionally, the second temperature is 70-150°C; and further optionally, the second temperature is 90-150°C.

12. The thin film mask according to claim 10, wherein the peeling strength of the unidirectional thermo-sensitive adhesive is 5-30 gf/cm and the temperature is 50-140°C.

13. The thin film mask according to claim 1, wherein a material of the adhesive film in the second layer comprises a bidirectional thermo-sensitive adhesive, a viscosity of the bidirectional thermo-sensitive adhesive exhibits reversibility under different temperature conditions; and
a peeling strength of the bidirectional thermo-sensitive adhesive increases with increasing of a temperature.

14. The thin film mask according to claim 13, wherein the peeling strength of the bidirectional thermo-sensitive adhesive is 5-30 gf/cm and the temperature is 50-140°C.

15. The thin film mask according to claim 1, wherein a thickness of the thin film mask is 10-100 µm; optionally, the thickness of the thin film mask is 10-50 µm.

16. The thin film mask according to claim 1, wherein the thin film mask further comprises a third layer;
the third layer is arranged in layer configuration at a side of the second layer away from the first layer;
the third layer comprises a release film; and
the release film is a polymer, comprising one or more of polyethylene glycol terephthalate, polyolefin thin film, polyimide, polyvinyl chloride, and biaxially oriented polypropylene.

17. The thin film mask according to claim 16, wherein a thickness of the third layer is 1-100 µm; optionally, the thickness of the third layer is 5-40 µm; and further optionally, the thickness of the third layer is 10-25 µm.

18. A deposition process for a solar cell, **characterized in that** the thin film mask according to any one of claims 1-15 is used in the deposition process.

19. The deposition process according to claim 18, wherein the deposition process comprises a functional layer deposition process and/or a conductive layer deposition process;
wherein the functional layer deposition comprises a dielectric layer deposition; and the conductive layer deposition comprises a transparent conductive layer deposition and/or a metal conductive layer deposition.
